# EUROPEAN PATENT APPLICATION

(11) **EP 1 685 971 A1**
(43) Date of publication of application: **02.08.2006**
(21) Application number: 04792508.6
(22) Date of filing: 15.10.2004
(51) Int. Cl.: B41M 5/26, G11B 7/24, G11B 7/26, C23C 14/34

(54) **PHASE TRANSITION TYPE OPTICAL RECORDING MEDIUM, PROCESS FOR PRODUCING THE SAME, SPUTTERING TARGET, METHOD OF USING OPTICAL RECORDING MEDIUM AND OPTICAL RECORDING APPARATUS**

(30) Priority: 16.10.2003 JP 2003355932; 21.11.2003 JP 2003393139
(71) Applicant: Ricoh Company, Ltd., Tokyo 143-8555 (JP)
(72) Inventor: OHKURA, Hiroko Ricoh Company, Ltd., Ohta-ku Tokyo 1438555 (JP); ITO, Kazunori Ricoh Company, Ltd., Ohta-ku Tokyo 1438555 (JP); DEGUCHI, Hiroshi Ricoh Company, Ltd., Ohta-ku Tokyo 1438555 (JP); KATO, Masaki Ricoh Company, Ltd., Ohta-ku Tokyo 1438555 (JP); ABE, Mikiko Ricoh Company, Ltd., Ohta-ku Tokyo 1438555 (JP); SEKIGUCHI, Hiroyoshi Ricoh Company, Ltd., Ohta-ku Tokyo 1438555 (JP)
(74) Representative: Barz, Peter
(86) International application number: PCT/JP2004/015291
(87) International publication number: WO 2005/037566

(57) **Abstract**

The object of the present invention is to provide a phase-change optical recording medium which excels in homogeneity within periphery after initial crystallization, has as much capacity as DVD-ROM, exhibits intense modulation degree even at a recording speed of DVD 8 double-speed (approximately 28 m/s) or more and less fluctuation in reflectance of crystalline phase even after long-term storage and is capable of overwrite recording. Therefore, provided is a phase-change optical recording medium containing a substrate, and at least a first intermediate layer, a recording layer, a second intermediate layer, and a reflective layer disposed on the substrate in one of this order and reverse order, wherein the recording layer contains a composition expressed by the following formula, Ga_{α}Sn_{β}Cu_{γ}Sb_{δ}M_{ε} where "M" represents at least one element selected from elements and mixtures thereof other than Ga, Sn, Cu and Sb and α, β, γ, δ and ε respectively represent atomic composition ratio of each element and satisfy the following relations: 5 ≤ α ≤ 20, 2 ≤ β ≤ 30, 1 ≤ γ ≤ 20, 40 ≤ δ < 80, 0 ≤ ε ≤ 20 and α + β + γ + δ + ε = 100.

## Description

### Technical Field

The present invention relates to phase-change optical recording medium (hereafter, may be referred to as "phase-change optical information recording medium", "optical recording medium", "optical information recording medium" or "information recording medium") which is capable of performing at least one of recording, reproducing, erasing or rewriting of information by an optical change in the material forming a recording layer induced by laser beam irradiation, manufacturing method of the phase-change optical recording medium, sputtering target, method for using the phase-change optical recording medium and optical recording apparatus.

### Background Art

Presently, a recording material for DVD (Digital Versatile Disk) system which can perform a speed recording at 2.5 double speed (about 8.5m/s) has been developed and the demand for high-speed recording is further increasing. The phase-change recording material used for DVD+RW is a AgInSbTe material employed for CD-RW which has been reformed to be capable of recording and erasing at high linear velocity. Since this AgInSbTe material corresponds to a recording speed of high linear velocity region, a material in which the content of Sb is adjusted to be higher than that of recording material applicable for CD-RW is being used. However, the material of high Sb content has a problem of lowering the crystallization temperature even though the crystallization speed is increased. A decrease in crystallization temperature causes deterioration of storage reliability. The problem of storage reliability of such disc has been controlled by increasing Ag content in the recording material or by adding a quintessence such as Ge to keep it in an acceptable level from a practical standpoint. However, an increase in the content of Sb for further achieving a recording at a high linear velocity causes phase separation and the recording layer does not function as a phase change layer. The maximum recording speed at this time is estimated to be approximately 18m/s.

Consequently, the present inventors focused on GaSb-based material as an alternative to AgInSbTe material, for high-speed recording material of the next generation. The crystallization speed near GaSb eutectic composition is high because of high Sb content and a significant amount of energy is needed to cut the eutectic bonding and modify the network for thermal crystallization of amorphous phase because of strong binding force between Ga and Sb, the GaSb-based material excels in stability of amorphous marks. And the present inventors have reported at the 14th Symposium on Phase Change Optical Information Storage (Nonpatent Literature 1) that an optical recording medium, which uses GaSb eutectic composition alloy as a recording layer, is capable of performing repetitive recording at a high linear velocity of DVD 8 double-speed.

Later, a recording material containing Sn has been found to have excellent properties as a material with which initial crystallization is performed more easily than near GaSb eutectic composition and the modulation degree becomes intense. However, when Sn is added to the GaSb eutectic composition alloy, a new problem arises such that the reflectance is significantly degraded by long-term storage.

A known technique, in which a recording material wherein a metal or chalcogenide element M is added to an alloy of GaSb or InSb with a composition ratio of approximately 50:50 is used, is proposed in Patent Literature 1 as a technique other than the above mentioned techniques. In the Patent Literature 1, it is stated that "even though amorphousization cannot be performed only with GaSb or InSb because of too much speed for crystallization, the crystallization speed can be slowed by adding a metal or chalcogenide element M, enabling to perform recording of information using phase transitions between amorphous and crystalline state".

However, the alloy near Ga₅₀Sb₅₀ composition has a high melting point of 710°C and crystallization temperature of 350°C and requires more power than that of the initialization apparatuses which are commercially available now. It is therefore impossible to obtain uniform crystalline state within periphery for initial crystallization and the reflectance becomes uneven. When a mark is recorded in this uneven state of reflectance, the noise of signals increase and it is difficult to record a signal particularly with high density such as for DVD.

Furthermore, a phase-change optical recording medium using an alloy consisting mainly of GaSb as a recording material is disclosed in Patent Literature 2. However, information is recorded in the optical recording medium using phase changes between crystals and the modulation degree is 29% at most, which is posing a practical issue for the recording medium. In the Patent Literature 2, it is stated that "when Ga is less than 20%, an embossment, which is thought to be caused by air bubbles generated in the laser beam irradiation part, occurs which result in unstable changing level of reflectance and poses a practical issue". Moreover, it is unsuitable for recording of information at high density where it is necessary to record fine marks because differences in reflectance due to differences in particle diameter of crystals is used for the phase changes between crystals. And it is also difficult to perform recording of information on the optical recording medium of the Patent Literature 2 at the same density as for DVD-ROM.

Furthermore, recordable optical recording media using recording materials expressed by the composition formula, InₓSb_{y}Sn_{z} (where 5 ≤ x ≤ 25, 45 ≤ y ≤ 80 and 10 ≤ z ≤ 38) are disclosed in Patent Literatures 3 and 4; however, these are recordable types and not rewritable optical recording media.

And an optical recording medium using a recording material expressed by the composition formula, CuₓSb_{y}Te_{(100-x-y)} (where 5 ≤ x ≤ 20 and 40 ≤ y ≤ 55) is disclosed in Patent Literature 5. However, the object of this proposal is to provide an optical recording medium which retains its original condition after many times of overwrite recording and erasing with a laser diode of low power and is capable of stable recording even at a relatively slow scanning speed of the optical beam, and it is not for achieving high-speed recording or DVD 8 double-speed or more.

Therefore, a phase-change optical recording medium, which excels in homogeneity within periphery after initial crystallization, has as much capacity as DVD-ROM, exhibits intense modulation degree even at a recording speed of DVD 8 double-speed (about 28 m/s) or more and less fluctuation in reflectance of crystalline phase even after long-term storage and is capable of overwrite recording, has not yet been provided and its soon provision is desired under current circumstances.
[Patent Literature 1] US Patent No. 4818666
[Patent Literature 2] Japanese Patent Application Laid-Open (JP-A) No. 61-168145
[Patent Literature 3] JP-A No. 9-286174
[Patent Literature 4] JP-A No. 9-286175
[Patent Literature 5] Japanese Patent (JP-B) No. 2867390
[Nonpatent Literature 1] The 14th Symposium on Phase Change Optical Information Storage p.11 "Characterization of GaSb Phase-Change Material of High-Speed ReWritable Media"

### Disclosure of Invention

The object of the present invention is to provide a phase-change optical recording medium of high quality, which excels in homogeneity within periphery after initial crystallization, has as much capacity as DVD-ROM, exhibits intense modulation degree even at a recording speed of DVD 8 double-speed (approximately 28 m/s) or more and less fluctuation in reflectance of crystalline phase even after long-term storage and is capable of overwrite recording, manufacturing method of the phase-change optical recording medium, sputtering target, method for using the phase-change optical recording medium and optical recording apparatus to settle above issues and respond to the demand.

A dedicated investigation on an alloy near GaSb eutectic composition which has excellent properties has been carried out by the present inventors to settle above issues and to put a phase-change optical recording medium capable of high-speed recording into practical use. As a result, it turns out that it is possible to provide a phase-change optical recording medium of high quality, which excels in homogeneity within periphery after initial crystallization, is capable of overwrite recording with as much capacity as DVD-ROM even at a recording speed of DVD 8 double-speed (about 28 m/s) or more and exhibits less fluctuation in reflectance of crystalline phase even after long-term storage, by using a recording layer material of a composition expressed by the next formula, Ga_{α}Sn_{β}Cu_{γ}Sb_{δ}M_{ε} where "M" represents at least one element selected from elements and mixtures thereof other than Ga, Sn, Cu and Sb and α, β, γ, δ and ε respectively represent atomic composition ratio of each element and satisfy the following relations: 5 ≤ α ≤ 20, 2 ≤ β ≤ 30, 1 ≤ γ ≤ 20, 40 ≤ δ < 80, 0 ≤ ε ≤ 20 and α + β + γ + δ + ε = 100, and a composition where "M" represents In in particular.

The present invention is based on the knowledge of the present inventors and the measures to solve above-mentioned problems are as follow.
<1> A phase-change optical recording medium containing a substrate, and at least a first intermediate layer, a recording layer, a second intermediate layer, and a reflective layer disposed on the substrate in one of this order and reverse order, wherein the recording layer contains a composition expressed by the following formula, Ga_{α}Sn_{β}Cu_{γ}Sb_{δ}M_{ε} where "M" represents at least one element selected from elements and mixtures thereof other than Ga, Sn, Cu and Sb and α, β, γ, δ and ε respectively represent atomic composition ratio of each element and satisfy the following relations: 5 ≤ α ≤ 20, 2 ≤ β ≤ 30, 1 ≤ γ ≤ 20, 40 ≤ δ < 80, 0 ≤ ε ≤ 20 and α + β + γ + δ + ε = 100.
   Because the recording layer of the phase-change optical recording medium of the present invention contains the above composition, it is possible to provide a phase-change optical recording medium which excels in storage stability and is capable of overwrite recording with as much capacity as DVD-ROM and at a recording linear velocity of DVD 8 double-speed (about 28m/s) or more.
<2> The phase-change optical recording medium as stated in above <1>, wherein the recording layer contains the composition expressed by the following formula, Ga_{α}Sn_{β}Cu_{γ}Sb_{δ} where α, β, γ and ε respectively represent atomic composition ratio of each element and satisfy the following relations: 5 ≤ α ≤ 20, 10 ≤ β ≤ 30, 1 ≤ γ ≤ 20, 40 ≤ δ < 80 and α + β + γ + δ = 100.
<3> The phase-change optical recording medium as stated in above <2>, wherein the recording layer contains the composition expressed by the following formula, Ga_{α}Sn_{β}Cu_{γ}Sb_{δ} where α, β, γ and ε respectively represent atomic composition ratio of each element and satisfy the following relations: 5 ≤ α ≤ 15, 15 ≤ β ≤ 25, 1 ≤ γ ≤ 15, 50 ≤ δ ≤ 75 and α + β + γ + δ = 100.
   The phase-change optical recording medium as stated in any one of above <2> and <3>, which excels in homogeneity within periphery after initial crystallization, has as much capacity as DVD-ROM, is capable of overwrite recording even at a recording linear velocity of DVD 8 double-speed (about 28m/s) or more and exhibits less fluctuation in reflectance after long-term storage, can be provided.
<4> The phase-change optical recording medium as stated in above <1>, wherein "M" is at least one selected from In, Te, Bi, Al, Zn, Ni, Mn, Cr, Mo and Hf.
<5> The phase-change optical recording medium as stated in any one of above <1> to <4>, wherein the recording layer contains a composition expressed by the following formula, Ga_{α}Sn_{β}Cu_{γ}Sb_{δ}In_{ε} where α, β, γ, δ and ε respectively represent atomic composition ratio of each element and satisfy the following relations: 5 ≤ α ≤ 20, 2 ≤ β ≤ 20, 1 ≤ γ ≤ 20, 40 ≤ δ < 80, 2 ≤ ε ≤ 20 and α + β + γ + δ + ε = 100.
<6> The phase-change optical recording medium as stated in above <5>, wherein the recording layer contains the composition expressed by the following formula, Ga_{α}Sn_{β}Cu_{γ}Sb_{δ}In_{ε} where α, β, γ, δ and ε respectively represent atomic composition ratio of each element and satisfy the following relations: 8 ≤ α ≤ 16, 5 ≤ β ≤ 15, 1 ≤ γ ≤ 15, 55 ≤ δ ≤ 75, 5 ≤ ε ≤ 15 and α + β + γ + δ + ε = 100.
   The phase-change optical recording medium as stated in any one of above <4> to <6>, which excels in homogeneity within periphery after initial crystallization, has as much capacity as DVD-ROM, is capable of overwrite recording even at a recording linear velocity of DVD 10 double-speed (about 35m/s) or more and exhibits less fluctuation in reflectance after long-term storage, can be provided.
<7> The phase-change optical recording medium as stated in any one of above <1> to <6>, wherein at least one of recording, reproducing, erasing and rewriting of information is performed in the recording layer through reversible phase changes between amorphous phase and crystalline phase.
<8> The phase-change optical recording medium as stated in any one of above <1> to <7>, wherein the first intermediate layer and the second intermediate layer contain a mixture of ZnS and SiO₂.
<9> The phase-change optical recording medium as stated in above <1> to <8>, wherein an interface layer is disposed between the recording layer and the first intermediate layer.
<10> The phase-change optical recording medium as stated in any one of above <1> to <9>, wherein the reflective layer contains one of Ag and Ag alloy.
<11> The phase-change optical recording medium as stated in any one of above <1> to <10>, wherein the thickness of the reflective layer is 60nm to 300nm.
<12> The phase-change optical recording medium as stated in above <11>, wherein the thickness of the reflective layer is 120nm to 250nm.
<13> The phase-change optical recording medium as stated in any one of above <1> to <12>, wherein a third intermediate layer is disposed between the second intermediate layer and the reflective layer.
   It is possible to prevent sulfurization of Ag and ensure the reliability of the phase-change optical recording medium as stated in any one of above <8> to <13> by forming the reflective layer with one of Ag and Ag alloy, forming the second protective layer with a mixture of ZnS and SiO₂ and disposing a third protective layer which does not contain sulfur between the second protective layer and the reflective layer.
<14> A sputtering target containing a composition expressed by the following formula, Ga_{α}Sn_{β}Cu_{γ}Sb_{δ}M_{ε} where "M" represents at least one element selected from elements and mixtures thereof other than Ga, Sn, Cu and Sb and α, β, γ, δ and ε respectively represent atomic composition ratio of each element and satisfy the following relations: 5 ≤ α ≤ 20, 2 ≤ β ≤ 30, 1 ≤ γ ≤ 20, 40 ≤ δ < 80, 0 ≤ ε ≤ 20 and α + β + γ + δ + ε = 100, and wherein the sputtering target is used for manufacturing the recording layer.
<15> The sputtering target as stated in above <14>, wherein the sputtering target contains the composition expressed by the following formula, Ga_{α}Sn_{β}Cu_{γ}Sb_{δ} where α, β, γ and δ respectively represent atomic composition ratio of each element and satisfy the following relations: 5 ≤ α ≤ 20, 10 ≤ β ≤ 30, 1 ≤ γ ≤ 20, 40 ≤ δ < 80 and α + β + γ + δ = 100.
<16> The sputtering target as stated in above <15>, wherein the sputtering target contains the composition expressed by the following formula, Ga_{α}Sn_{β}Cu_{γ}Sb_{δ} where α, β, γ and δ respectively represent atomic composition ratio of each element and satisfy the following relations: 5 ≤ α ≤ 15, 15 ≤ β ≤ 25, 1 ≤ γ ≤ 15, 50 ≤ δ ≤ 75 and α + β + γ + δ = 100.
<17> The sputtering target as stated in above <14>, wherein "M" is at least one selected from In, Te, Bi, Al, Zn, Ni, Mn, Cr, Mo and Hf.
<18> The sputtering target as stated in any one of above <14> to <17>, wherein the sputtering target contains the composition expressed by the following formula, Ga_{α}Sn_{β}Cu_{γ}Sb_{δ}In_{ε} where α, β, γ, δ and ε respectively represent atomic composition ratio of each element and satisfy the following relations: 5 ≤ α ≤ 20, 2 ≤ β ≤ 20, 1 ≤ γ ≤ 20, 40 ≤ δ < 80, 2 ≤ ε ≤ 20 and α + β + γ + δ + ε = 100.
<19> The sputtering target as stated in above <18>, wherein the sputtering target contains the composition expressed by the following formula, Ga_{α}Sn_{β}Cu_{γ}Sb_{δ}In_{ε} where α, β, γ, δ and ε respectively represent atomic composition ratio of each element and satisfy the following relations: 8 ≤ α ≤ 16, 5 ≤ β ≤ 15, 1 ≤ γ ≤ 15, 55 ≤ δ ≤ 75, 5 ≤ ε ≤ 15 and α + β + γ + δ + ε = 100.
   A desired recording layer composition can be obtained by forming a recording layer by sputtering using the sputtering target as stated in any one of above <14> to <19>, an alloy target of predefined composition, and an optical recording medium, which is applicable for recording speed of DVD 8 double-speed (about 28m/s) ore more can be stably provided.
<20> A manufacturing method of a phase-change optical recording medium containing recording-layer forming to form a recording layer by sputtering using the sputtering target according to any one of above <14> to <19>, wherein the phase-change optical recording medium comprises a first intermediate layer, a recording layer, a second intermediate layer and a reflective layer disposed on the substrate in one of this order and reverse order.
   At least one of recording, reproducing, erasing and rewriting of information is performed by irradiating a laser beam to the phase-change optical recording medium of the present invention in the method for using the phase-change optical recording medium of the present invention. As a result, one of recording, reproducing, erasing and rewriting can be stably and effectively performed without fail.
<21> A method for using a phase-change optical recording medium containing a laser beam irradiation from the first intermediate layer side of the phase-change optical recording medium to perform at least one of recording, reproducing, erasing and rewriting of information, wherein the phase-change optical recording medium is the phase-change optical recording medium according to any one of above <1> to <13>.
   At least one of recording, reproducing, erasing and rewriting of information is performed by irradiating a laser beam to the phase-change optical recording medium of the present invention in the method for using the phase-change optical recording medium of the present invention. As a result, one of recording, reproducing, erasing and rewriting can be stably and effectively performed without fail.
<22> An optical recording apparatus containing a laser beam source configured to irradiate a laser beam to a phase-change optical recording medium to perform at least one of recording, reproducing, erasing and rewriting of information, wherein the phase-change optical recording medium is the phase-change optical recording medium according to any one of above <1> to <13>.

At least one of recording, reproducing, erasing and rewriting of information is performed by irradiating a laser beam to a phase-change optical recording medium in the optical recording apparatus of the present invention and the phase-change optical recording medium is the phase-change optical recording medium of the present invention. In the optical recording apparatus of the present invention, one of recording, reproducing, erasing and rewriting can be stably and effectively performed without fail.

### Brief Description of Drawings

FIG. 1 is a schematic cross-sectional diagram showing an example of basic layer composition of the phase-change optical recording medium of the present invention.
FIG.2 is a graph showing a relation between the layer thickness of the reflective layer and the changes in modulation degree of Example 11.
FIG. 3 is a diagram showing repetition performance at a recording linear velocity of 28 m/s of Examples 4 and 12.
FIG. 4 is a graph showing a relation between the layer thickness of the reflective layer and the changes in modulation degree of Example 22.
FIG. 5 is a diagram showing repetition performance at a recording linear velocity of 35m/s of Examples 14 and 23.

### Best Mode for Carrying Out the Invention

### (Phase-Change Optical Recording Medium)

The phase-change optical recording medium of the present invention has a substrate and at least a first intermediate layer, a recording layer, a second intermediate layer and a reflective layer disposed on the substrate in one of this order and reverse order and further contains other layers as necessary.

In the present case, at least one of recording, reproducing, erasing and rewriting of information is performed by irradiating a laser beam from the first intermediate layer side of the phase-change optical recording medium.

### -Recording Layer-

Recording and erasing of signals are performed in the recording layer by irradiating a laser beam to induce phase changes between crystalline phase and amorphous phase. In this case, the reflectance differs between crystalline phase and amorphous phase and generally, unrecorded state is defined as a crystalline phase of high reflectance and an amorphous mark of low reflectance is recorded as a signal by quenching the recording layer after irradiating a pulsed laser beam of high power to the crystalline phase to heat the recording layer.

It excels in stability of amorphous marks because speeding up of crystallization is possible near GaSb eutectic composition and a significant amount of energy is needed to cut the eutectic bonding and modify the network in order to thermally crystallize the amorphous phase because of strong binding force between Ga and Sb.

However, there is a disadvantage such that the initial crystallization in initialization process, in which amorphous phase of the recording layer at the time of film formation is changed to crystalline phase of unrecorded state, is difficult because of high crystallization temperature of GaSb.

By having GaSb alloy as a parent phase and further adding Sn to the recording layer, it is possible to overcome disadvantage of GaSb such that the initial crystallization is difficult due to high crystallization temperature, and to achieve more speeding up of crystallization and sufficient modulation degree. It is possible to overcome disadvantage of GaSb by adding Sn, however, as content of Sn increases, crystalline phase of unrecorded state is likely to phase transit to crystalline state of low reflectance, which exhibit lower reflectance than that of crystalline phase of high reflectance, and poses a new problem such that the reflectance of the crystalline phase is significantly deteriorated after long-term storage.

When the reflectance of crystalline phase of unrecorded state changes, optical properties significantly changes and it becomes difficult to record a signal with the same recording condition. The recording condition of rewritable drives which are actually available in the market is fixed corresponding to the optical recording medium immediately after production. If the reflectance is significantly changed after long-term storage, it becomes impossible to record a signal in the optical recording medium and such optical recording medium cannot be offered commercially.

The reason for reflectance deterioration of GaSbSn alloy in this case is thought to be as follow. Many holes exist in the crystalline phase after laser beam irradiation and the crystalline phase is in a condition of being distorted. The distortion is relaxed with time and it is changed to the crystalline phase of low reflectance, which exhibits lower reflectance than that of crystalline phase after laser beam irradiation.

To settle above issue, the reflectance deterioration after long-term storage can be suppressed by further adding other metals, at least one of Cu and In for example, to GaSbSn alloy. This is thought to because when at least one of Cu and In is added, holes seen in GaSbSn alloy are filled with Cu and In, resulting in a crystal of less distortion and the reflectance is not likely to be deteriorated. It is possible to pursue high crystallization speed and less fluctuation in reflectance simultaneously by using a combination of Cu and In among them.

Therefore, the recording layer contains a composition expressed by the next formula, Ga_{α}Sn_{β}Cu_{γ}Sb_{δ}M_{ε} where "M" represents at least one element selected from elements and mixtures thereof other than Ga, Sn, Cu and Sb and α, β, γ, δ and ε respectively represent atomic composition ratio of each element and satisfy the following relations: 5 ≤ α ≤ 20, 2 ≤ β ≤ 30, 1 ≤ γ ≤ 20, 40 ≤ δ < 80, 0 ≤ ε ≤ 20 and α + β + γ + δ + ε = 100. In this case, it is preferable to contain the composition expressed by the next formula, Ga_{α}Sn_{β}Cu_{γ}Sb_{δ}M_{ε} and the following are true: 5 ≤ α ≤ 15, 2 ≤ β ≤ 20, 1 ≤ γ ≤ 15, 60 ≤ δ < 75, 0 ≤ ε ≤ 15 and α + β + γ + δ + ε = 100. It is preferable for "M" to be at least one selected from In, Te, Bi, Al, Zn, Ni, Mn, Cr, Mo and Hf and of these, In is particularly preferable.

The first embodiment of the recording layer, which is preferable for performing overwrite recording at DVD 8 double-speed (about 28m/s) or more with as much capacity as DVD-ROM, is preferably containing a composition expressed by the next formula, Ga_{α}Sn_{β}Cu_{γ}Sb_{δ} where α, β, γ and δ respectively represent atomic composition ratio of each element and satisfy the following relations: 5 ≤ α ≤ 20, 10 ≤ β ≤ 30, 1 ≤ γ ≤ 20, 40 ≤ δ < 80 and α + β + γ + δ = 100. And it is more preferably containing a composition expressed by the next formula, Ga_{α}Sn_{β}Cu_{γ}Sb_{δ} where α, β, γ and δ respectively represent atomic composition ratio of each element and satisfy the following relations: 5 ≤ α ≤ 15, 15 ≤ β ≤ 25, 1 ≤ γ ≤ 15, 50 ≤ δ < 75 and α + β + γ + δ = 100 in terms of further improving repetition performance.

When Ga is less than 5 atomic%, it is difficult for amorphousization to take place and modulation degree and recording jitter may be deteriorated. When Ga is more than 20 atomic%, the crystallization speed is slowed too much and repetitive recording at DVD 8 double-speed (about 28m/s) or more may be impossible. Furthermore, when Sn is less than 10 atomic%, initial crystallization cannot be performed uniformly and when Sn is more than 30 atomic%, the crystallization speed is increased too much and amorphousization may be difficult. And when Cu is less than 1 atomic%, reflectance fluctuation after long-term storage becomes large, and when Cu is more than 20 atomic%, the crystallization speed is slowed too much and repetitive recording at DVD 8 double-speed (about 28m/s) or more may be impossible. Moreover, when Sb is less than 40 atomic%, amorphousization is difficult and when Sb is more than 80 atomic%, homogeneity within periphery after initialization may be deteriorated.

The second embodiment of the recording layer, which is preferable for performing overwrite recording at DVD 10 double-speed (about 35m/s) or more with as much capacity as DVD-ROM is preferably containing a composition expressed by the next formula, Ga_{α}Sn_{β}Cu_{γ}Sb_{δ}In_{ε} where α, β, γ, δ and ε respectively represent atomic composition ratio of each element and satisfy the following relations: 5 ≤ α ≤ 20, 2 ≤ β ≤ 20, 1 ≤ γ ≤ 20, 40 ≤ δ < 80, 2 ≤ ε ≤ 20 and α + β + γ + δ + ε = 100. And it is more preferably containing a composition expressed by the next formula, Ga_{α}Sn_{β}Cu_{γ}Sb_{δ}In_{ε} where the following are true: 8 ≤ α ≤ 16, 5 ≤ β ≤ 15, 1 ≤ γ ≤ 15, 55 ≤ δ < 75, 5 ≤ ε ≤ 15 and α + β + γ + δ + ε = 100.

When Ga is less than 5 atomic%, the stability of amorphous phase is deteriorated and when Ga is more than 20 atomic%, the crystallization speed is slowed too much and repetitive recording at DVD 10 double-speed or more may be impossible. When Sn is less than 2 atomic%, initial crystallization may not be performed uniformly and when Sn is more than 20 atomic%, the crystallization speed is increased too much and amorphousization may be difficult. Moreover, when Cu is less than 1 atomic%, reflectance fluctuation may become too large after long-term storage and when Cu is more than 20 atomic%, the crystallization speed is slowed too much and repetitive recording at DVD 10 double-speed may be impossible. And when In is less than 2 atomic%, repetitive recording performance at DVD 10 double-speed may be deteriorated and when In is more than 20 atomic%, the crystallization speed is increased too much and amorphousization may be difficult. Furthermore, when Sb is less than 40 atomic%, amorphousization is difficult and when Sb is more than 80 atomic%, homogeneity within periphery after initialization may be deteriorated.

Examples of the method for forming the recording layer include various vapor-phase growths such as vacuum evaporation, sputtering, plasma CVD, optical CVD, ion plating and electron-beam deposition. Among them, sputtering excels in mass productivity, layer quality, and the like. For example, the following sputtering condition is favorable: Ar gas as a film-forming gas, electricity input of 1kW and Ar gas pressure (air pressure of film-forming chamber) of 2 × 10⁻³ Torr.

The thickness of the recording layer is not particularly limited and may be adjusted accordingly. It is preferably 10nm to 30nm and more preferably 10nm to 20nm. When the thickness is less than 10nm, optical absorbing power is degraded and it may not function as a recording layer and when the thickness is more than 30nm, recording sensitivity may be deteriorated.

Next, an exemplary layer structure of the phase-change optical recording medium according to the present invention will be described in detail based on the accompanying drawing.

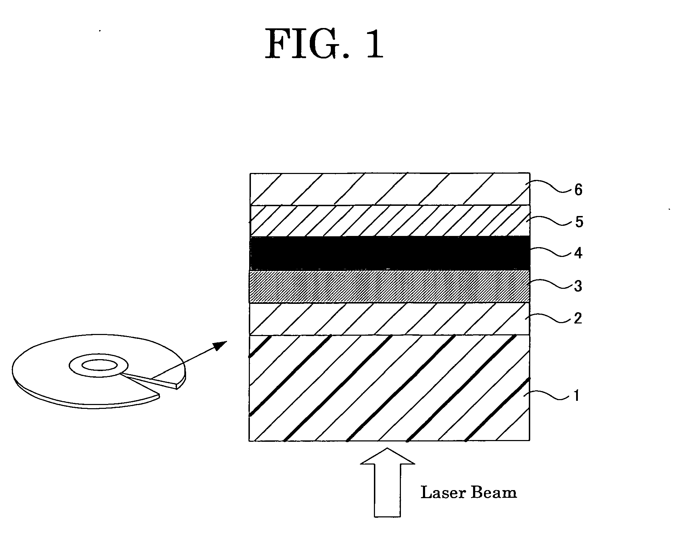

Here, FIG. 1 is a schematic cross-sectional view showing an exemplary phase-change optical recording medium according to the present invention, in which a substrate 1, a first intermediate layer 2, a recording layer 3, a second intermediate layer 4, a third intermediate layer 5 and a reflective layer 6 are laminated on the substrate 1 in the named order. In addition, it is preferable to dispose an interface layer between the recording layer 3 and the first intermediate layer 2, although not shown in the figures. Furthermore, it is also favorable to form a protective layer made of ultraviolet (UV) curable resin on the reflective layer by spincoating and other substrates may be bonded on the protective layer as necessary for further reinforcement or protection of the phase-change optical recording medium.

### -Substrate-

Generally, glass, ceramics, resin, and the like are used for the material of the substrate 1 and the substrate made of resin is preferable in terms of formability and cost. Examples of the resin include polycarbonate resin, acrylic resin, epoxy resin, polystyrene resin, acrylonitrile-styrene copolymer, polyethylene resin, polypropylene resin, silicone resin, fluorine resin, ABS resin, urethane resin, and the like. Of these, polycarbonate resin and acrylic resin are especially preferable in terms of formability, optical properties and cost.

The thickness of the substrate 1 is not particularly limited and the thickness is determined by wavelength of the laser or focusing property of the pickup lens generally used. The substrate having a thickness of 1.2mm is used for CD of 780nm wavelength and a substrate having a thickness of 0.6 mm is used for DVD of 650nm to 665nm wavelength.

A substrate of polycarbonate resin, which has a guide groove for tracking on its surface, is in form of a disc of 12cm diameter and 0.6mm thickness and has excellent workability and optical property, is favorable, for example. The guide groove for tracking is preferably a meandering groove within a range of 0.74 ± 0.03µm pitch, 22nm to 40nm groove depth and 0.2µm to 0.4µm groove width. In particular, by making the groove deep, reflectance of the phase-change optical recording medium decreases and the modulation degree becomes intense.

In addition, an adhesive layer for bonding the substrate 1 where information signal is written in, and the bonding substrate is formed of double-sided adhesive sheet of which binder is applied on both sides of the base film, thermal curable resin or ultraviolet curable resin. The thickness of the adhesive layer is generally about 50µm.

The bonding substrate (dummy substrate) is not necessarily transparent when the adhesive layer is an adhesive sheet or thermal curable resin, however, when the adhesive layer is an ultraviolet curable resin, it is favorable to use a transparent substrate through which ultraviolet ray is transmitted. In general, the thickness of the bonding substrate is preferably 0.6mm, as same as the transparent substrate 1 in which information signal is written in.

### -First Intermediate Layer-

The first intermediate layer 2 is preferably having good adhesiveness with the substrate and the recording layer, is highly thermostable, and is also preferably having optical properties suitable for repetitive recording at high linear velocity because it also serves as an optical interference layer which makes an effective light absorption of the recording layer possible.

Examples of the material for the first intermediate layer include metal oxides such as SiO, SiO₂, ZnO, SnO₂, Al₂O₃, TiO₂, In₂O₃, MgO and ZrO₂; nitrides such as Si₃N₄, AIN, TiN, BN and ZrN; sulfides such as ZnS, In₂S₃ and TaS₄; carbides such as SiC, TaC, B₄C, WC, TiC and ZrC; diamond-like carbon or mixtures thereof. Of these, a mixture of ZnS and SiO₂ is preferable. The mixture molar ratio (ZnS:SiO₂) is preferably 50 to 90 : 50 to 10 and more preferably 60 to 90 : 40 to 10.

Examples of the method for forming the first intermediate layer 2 include various vapor-phase growths such as vacuum evaporation, sputtering, plasma CVD, optical CVD, ion plating and electron-beam deposition. Among them, sputtering excels in mass productivity, layer quality, and the like. For example, the following sputtering condition is favorable: Ar gas as a film-forming gas, electricity input of 3kW and Ar gas pressure (air pressure of film-forming chamber) of 2 × 10⁻³ Torr.

The thickness of the first intermediate layer is not particularly limited and may be selected accordingly and it is preferably 40nm to 500nm and more preferably 60nm to 200nm. If the thickness is less than 40nm, the substrate may be deformed because when the recording layer is heated, the substrate is heated as well. If the thickness is more than 500nm, interfacial peeling between the substrate and the first intermediate layer may likely to occur.

### -Second Intermediate Layer-

The second intermediate layer 4 is preferably having good adhesiveness with the substrate and the recording layer, is highly thermostable and having optical properties suitable for repetitive recording at high linear velocity because it also serves as an optical interference layer which makes an effective light absorption of the recording layer possible.

Examples of the material for the second intermediate layer include metal oxides such as SiO, SiO₂, ZnO, SnO₂, Al₂O₃, TiO₂, In₂O₃, MgO and ZrO₂; nitrides such as Si₃N₄, AlN, TiN, BN and ZrN; sulfides such as ZnS, In₂S₃ and TaS₄; carbides such as SiC, TaC, B₄C, WC, TiC and ZrC; diamond-like carbon or mixtures thereof. Of these, a mixture of ZnS and SiO₂ is preferable. The mixture molar ratio (ZnS:SiO₂) is preferably 50 to 90 : 50 to 10 and more preferably 60 to 90 : 40 to 10.

Examples of the method for forming the second intermediate layer 4 include various vapor-phase growths such as vacuum evaporation, sputtering, plasma CVD, optical CVD, ion plating and electron-beam deposition. Among them, sputtering excels in mass productivity, layer quality, and the like. For example, the following sputtering condition is favorable: Ar gas as a film-forming gas, electricity input of 3kW and Ar gas pressure (air pressure of film-forming chamber) of 2 × 10⁻³ Torr.

The thickness of the second intermediate layer is not particularly limited and may be adjusted accordingly and it is preferably 5nm to 100nm and more preferably 5nm to 20nm. When the thickness is more than 100nm, too much heat may be gathered inside, making it difficult to form amorphous phase and when it is less than 5nm, recording sensitivity may be deteriorated.

### -Reflective Layer-

The reflective layer serves as an optical reflective layer while it also serves as a heat dissipation layer for dissipating heat added to the recording layer by laser beam irradiation during recording. Choosing a reflective layer is quite important for the phase-change optical recording medium corresponding to high linear velocity, because an amorphous mark forming is heavily affected by cooling rate through heat dissipation.

For the reflective layer 6, a metallic material, for example, Al, Au, Ag, Cu, Ta, and the like or metal alloys thereof can be used. Further, as an element to be added to these nietallic materials, Cr, Ti, Si, Cu, Ag, Pd, Ta or the like can be used. Among these materials, it is preferred that one of Ag and Ag metal alloy is contained therein. This is because a metal with high thermal conductivity and high reflectance is usually desirable for the reflective layer constituting the phase-change optical recording medium in terms of thermal conductivity for modulating cooling rate against the heat generated at the time of recording and also in terms of an optical viewpoint of improving the contrast of reproduction signals by utilizing interference effect, and pure Ag or an Ag metal alloy respectively has extremely high thermal conductivity of 427W/m·K, and a quenching structure suitable for forming an amorphous mark can be realized immediately after the recording layer acquires a high temperature at the time of recording.

Pure silver is the most suitable in consideration of its high thermal conductivity, but Cu may be added in consideration of corrosion resistance. In this case, in order not to impair the property of Ag, the range of the copper addition amount is preferably from about 0.1 atomic percent to about 10 atomic percent, and more preferably within the range of 0.5 atomic percent to 3 atomic percent. An excessive addition of copper may deteriorate high heat conductivity of Ag.

Examples of the method for forming the reflective layer 6 include various vapor-phase growths such as vacuum evaporation, sputtering, plasma CVD, optical CVD, ion plating and electron-beam deposition. Among them, sputtering excels in mass productivity, layer quality, and the like. For example, the following sputtering condition is favorable: Ar gas as a film-forming gas, electricity input of 5kW and Ar gas pressure (air pressure of film-forming chamber) of 2 × 10⁻³ Torr.

The thickness of the reflective layer is not particularly limited and may be adjusted accordingly and it is preferably 60nm to 300nm and more preferably 120nm to 250nm. When the thickness is less than 60nm, heat dissipation effect cannot be obtained and forming amorphous may be difficult and when the thickness is more than 300nm, interfacial peeling may likely to occur.

It is noted that a resin protective layer may be disposed on the reflective layer 6 as necessary. This resin protective layer has an effect of protecting recording layer in the process flow and when manufactured as a product, and it is usually formed through the use of an ultraviolet-curable resin. The thickness of the resin protective layer is preferably within the range of 2µm to 5µm.

### -Third Intermediate Layer-

It is preferred that the third intermediate layer 5 is disposed between the second intermediate layer 4 and the reflective layer 6.

Examples of material for the third intermediate layer 5 include Si, SiC, SiN, SiO₂, TiC, TiO₂, TiC-TiO₂, NbC, NbO₂, NbV-NbO₂, Ta₂O₅, Al₂O₃, ITO, GeN, ZrO₂, and the like. Among them, TiC-TiO₂, Si or SiC is particularly preferable in terms of high-barrier properties.

If a protective layer containing sulfur such as a mixture of ZnS and SiO₂ is used, and when pure Ag or Ag alloy is used for the reflective layer, sulfur will diffuse toward Ag and causes a problem of disc defects (sulfurization of Ag). Thus, for the third intermediate layer for preventing such reaction, it is desirable to select a proper material from the following perspectives:
(1) having barrier properties to prevent sulfurization of Ag; (2) being optically transparent to laser beam; (3) having low-thermal conductivity for forming an amorphous mark; (4) having good adhesion with protective layers and reflective layers; and (5) being easy to form. A material constituting mainly of TiC-TiO₂, Si or SiC that satisfies above conditions is suitable for constituent material of the third intermediate layer.
   The thickness of the third intermediate layer is preferably 2nm to 20nm, and more preferably 2nm to 10nm. If the thickness is less than 2nm, the third intermediate layer may not function as a barrier layer, and if the thickness is more than 20nm, the modulation degree may be lowered.

### Interface Layer-

It is preferred that an interface layer is disposed between the first intermediate layer 2 and the recording layer 3. The interface layer is preferably containing SiO₂ and having a thickness of 2nm to 10nm. This decreases damages of which the substrate receives when recording is performed at high power and gives advantageous effect on overwriting performance at high power recording; therefore having a wide margin of recording power is possible. If the thickness of the interface layer is less than 2nm, forming a uniform SiO₂ film may be difficult, and if the thickness is more than 10nm, film separation may be likely to occur.

The phase-change optical recording medium according to the present invention has been described in detail; however, the present invention is not limited to the disclosed embodiments and various modifications without departing from the scope of the present invention are acceptable. For example, the present invention may be applied to a phase-change optical recording medium in which the same or different types of two phase-change optical recording media are bonded together through a resin protective layer instead of a bonding substrate as seen in DVD system.

### (Sputtering Target)

Therefore, the sputtering target of the present invention is used for manufacturing the recording layer and contains a composition expressed by the next formula, Ga_{α}Sn_{β}Cu_{γ}Sb_{δ}M_{ε} where "M" represents at least one element selected from elements and mixtures thereof other than Ga, Sn, Cu and Sb and α, β, γ, δ, and ε respectively represent atomic composition ratio of each element and satisfy the following relations: 5 ≤ α ≤ 20, 2 ≤ β ≤ 30, 1 ≤ γ ≤ 20, 40 ≤ δ < 80, 0 ≤ ε ≤ 20 and α + β + γ + δ + ε = 100. In this case, it is preferable to contain the composition expressed by the next formula, Ga_{α}Sn_{β}Cu_{γ}Sb_{δ}M_{ε} where the following are true: 5 ≤ α ≤ 15, 2 ≤ β ≤ 20, 1 ≤ γ ≤ 15, 60 ≤ δ < 75, 0 ≤ ε ≤ 15 and α + β + γ + δ + ε = 100.

It is preferable for "M" to be at least one selected from In, Te, Bi, Al, Zn, Ni, Mn, Cr, Mo and Hf and among them, In is particularly preferable.

The first embodiment of the sputtering target is preferably containing a composition expressed by the next formula, Ga_{α}Sn_{β}Cu_{γ}Sb_{δ} where α, β, γ and δ respectively represent atomic composition ratio of each element and satisfy the following relations: 5 ≤ α ≤ 20, 10 ≤ β ≤ 30, 1 ≤ γ ≤ 20, 40 ≤ δ < 80 and α + β + γ + δ = 100 and it is more preferably containing a composition expressed by the next formula, Ga_{α}Sn_{β}Cu_{γ}Sb_{δ} where the following are true: 5 ≤ α ≤ 15, 15 ≤ β ≤ 25, 1 ≤ γ ≤ 15, 50 ≤ δ < 75 and α + β + γ + δ = 100.

The second embodiment of the sputtering target is preferably containing a composition expressed by the next formula, Ga_{α}Sn_{β}Cu_{γ}Sb_{δ}In_{ε} where α, β, γ, δ and ε respectively represent atomic composition ratio of each element and satisfy the following relations: 5 ≤ α ≤ 20, 2 ≤ β ≤ 20, 1 ≤ γ ≤ 20, 40 ≤ δ < 80, 2 ≤ ε ≤ 20 and α + β + γ + δ + ε = 100 and it is more preferably containing a composition expressed by the next formula, Ga_{α}Sn_{β}Cu_{γ}Sb_{δ}In_{ε} where the following are true: 8 ≤ α ≤ 16, 5 ≤ β ≤ 15, 1 ≤ γ ≤ 15, 55 ≤ δ ≤ 75, 5 ≤ ε ≤ 15 and α + β + γ + δ + ε = 100.

The manufacturing method of sputtering target is not particularly limited and may be selected accordingly and a certain prearranged amount is weighed and heat melted in a glass ampoule. And then it is pulverized by means of a pulverizer and obtained powder is heat sintered to manufacture a discoid sputtering target.

By the present invention, a phase-change optical recording medium, which is easy to perform initial crystallization, exhibits appropriate recording sensitivity at a linear velocity of DVD 8 double-speed (about 28m/s) or more with as much capacity as DVD-ROM, is capable of overwrite recording and excels storage reliability, can be provided.

Furthermore, the phase-change optical recording medium which exhibits appropriate repetitive recording performance at a wide region of recording linear velocity with as much capacity as DVD-ROM and the sputtering target for manufacturing the phase-change optical recording medium can be provided by the present invention.

### (Manufacturing Method of Phase-Change Recording Medium)

The manufacturing method of the phase-change recording medium of the present invention includes at least recording layer forming, initial crystallization and other steps as necessary.

### -Recording Layer Forming-

The recording layer forming is a step to form a recording layer by sputtering using the sputtering target of the invention.

The sputtering is not particularly limited and may be selected from known sputtering accordingly, for example, the sputtering using Ar gas as a film-forming gas, electricity input of 1kW to 5kW and gas flow rate of 10sccm to 40sccm is favorable. The Ar gas pressure inside the chamber during sputtering is preferably 7.0 × 10⁻³mTorr (mbar) or less.

### -Initial Crystallization-

The initial crystallization is a step to perform an initial crystallization at a power density of 15mW/µm² to 40mW/µm² while rotating the phase-change optical recording medium at a constant linear velocity within the range of 10m/s to 21m/s.

Specifically, the initial crystallization is performed by irradiating a recording light such as laser diode (with an emission wavelength of 600nm to 720nm, for example) from the substrate side via objective lens while rotating the phase-change optical recording medium at a constant linear velocity or constant angular velocity. The temperature of the recording layer increases locally as it absorbs irradiated light and information is recorded by generating a pit and modifying its optical property, for example. The reproduction of the above recorded information can be performed by irradiating a laser beam from the first intermediate layer side while rotating the phase-change optical recording medium at a constant linear velocity and detecting the reflected light.

### (Method for Using Phase-Change Optical Recording Medium)

In the method for using the phase-change optical recording medium of the invention, at least one of recording, reproducing, erasing and rewriting of information is performed by laser beam irradiation from the first intermediate layer side of the phase-change optical recording medium of the invention.

In the present case, the recording linear velocity of the optical recording medium is preferably DVD 8 double-speed (about 28m/s) or more, for example.

Specifically, a recording light such as laser diode (with an emission wavelength of 600nm to 720nm, for example) is irradiated from the substrate side via objective lens while rotating the phase-change optical recording medium at a constant linear velocity. The temperature of the recording layer increases locally as it absorbs irradiated light and information is recorded by generating a pit and modifying its optical property, for example. The reproduction of the above recorded information can be performed by irradiating a laser beam from the substrate side while rotating the phase-change optical recording medium at a constant linear velocity and detecting the reflected light.

### (Optical Recording Apparatus)

The recording of information is performed in a phase-change optical recording medium by irradiating a laser beam from a light source to the phase-change optical recording medium in the optical recording apparatus of the invention and the phase-change optical recording medium is the phase-change optical recording medium of the invention.

The optical recording apparatus is not limited and may be selected accordingly and the example of such apparatus is equipped with a laser beam source, which is a light source for laser diode, and the like which emits laser beams; a focusing lens which focuses the laser beam emitted from the laser beam source to the optical recording medium mounted on a spindle; optical elements which guides the laser beam emitted from the laser beam source to both of the focusing lens and a laser beam detector; the laser beam detector for detecting the reflected light of the laser beam and contains other units as necessary.

The laser beam emitted from the laser beam source is led to the focusing lens through optical elements to perform recording in a phase-change optical recording medium by concentrating and irradiating the laser beam through focusing lens to the phase-change optical recording medium in the optical recording apparatus. At this time, the reflected light of the laser beam is led to the laser beam detector to control the light amount of the laser beam source based on the amount of the laser beam detected by the laser beam detector in the optical recording apparatus.

The detected amount of the laser beam is converted into power voltage or power current and generated as a detected amount signal.

Examples of other units include control unit. The control unit is not particularly limited as long as it is able to control movements of the individual units, and may be selected accordingly and examples of control unit include equipments such as sequencers for irradiating and scanning intensity-modulated laser beams, computers, and the like.

By the present invention, a phase-change optical recording medium, which excels in homogeneity within periphery after initial crystallization, has as much capacity as DVD-ROM, is capable of overwrite recording even at a recording linear velocity of DVD 8 double-speed (about 28m/s) or more and has less fluctuation in reflectance of crystalline phase even after long-term storage, can be provided.

And by the present invention, a phase-change optical recording medium which excels in overwriting performance with intense modulation degree can be provided.

### Example

Herein below, the invention is explained in detail with referring to Examples; however, Examples should not be construed as limiting the scope of the invention.

### (Example 1)

### -Preparation of Phase-Change Optical Recording Medium-

A polycarbonate resin substrate of 12cm diameter and 0.6mm thickness, having a guide groove of 0.74µm track pitch and 400Å groove depth, was provided. On the substrate, a first intermediate layer, a recording layer, a second intermediate layer, a third intermediate layer and a reflective layer are formed in this order by sputtering using a sheet sputtering apparatus (Big Sprinter by Unaxis Incorporated) under Ar gas atmosphere.

First, using a sputtering target of (ZnS)₈₀ (SiO₂)₂₀ composition (mole percent), a first intermediate layer of 70nm thickness was formed on the substrate by sputtering.

Next, using a sputtering target of Ga₅Sn₁₅Cu₅Sb₇₅ composition (atomic percent), a recording layer of 16nm thickness was formed on the first intermediate layer by sputtering. The target for the recording layer was made into a form of a disk by weighing the feed amount in advance, pulverizing by means of a pulverizer after being heat melted in a glass ampoule and taken out, and then heat sintering the obtained powder. When the composition ratio of the recording layer after formation was measured by inductively-coupled plasma (ICP) emission spectrometry, it was the same composition ratio as that of feed amount of the target. A sequential ICP emission spectrophotometer (SPS4000 by Seiko Instruments Inc.) was used for the ICP emission spectrometry. Meanwhile, the alloy compositions of the recording layer and sputtering target are identical to each other in Examples and Comparative Examples, which will be described later.

Next, using the sputtering target of (ZnS)₈₀ (SiO₂)₂₀ composition (mole percent), a second intermediate layer of 10nm thickness was formed on the recording layer by sputtering.

Next, using a sputtering target of SiC, a third intermediate layer of 4nm thickness was formed on the second intermediate layer by sputtering.

Next, using a sputtering target of Ag, a reflective layer of 140nm thickness was formed on the third intermediate layer by sputtering.

Next, an organic protective layer was formed by applying acrylic curable resin (SD318 by Dainippon Ink and Chemicals, Inc.) of 5µm to 10µm thickness on the reflective layer by spincoating and ultraviolet-curing.

Finally, a polycarbonate resin substrate of 12cm diameter and 0.6mm thickness was bonded onto the organic protective layer using an ultraviolet curable resin (DVD003 by Nippon Chemical Industrial Co., Ltd.). With the above procedures, the phase-change optical recording medium of Example 1 was prepared.

### (Example 2)

### -Preparation of Phase-Change Optical Recording Medium-

The phase-change optical recording medium of Example 2 was prepared similarly to Example 1, except for forming a recording layer by sputtering using a sputtering target of Ga_{6.5}Sn₂₅Cu_{8.5}Sb₆₀ composition (atomic%).

### (Example 3)

### -Preparation of Phase-Change Optical Recording Medium-

The phase-change optical recording medium of Example 3 was prepared similarly to Example 1, except for forming a recording layer by sputtering using a sputtering target of Ga₁₄Sn₂₀Cu₁₂Sb₅₄ composition (atomic%).

### (Example 4)

### -Preparation of Phase-Change Optical Recording Medium-

The phase-change optical recording medium of Example 4 was prepared similarly to Example 1, except for forming a recording layer by sputtering using a sputtering target of Ga₅Sn₂₀Cu₁₀Sb₆₅ composition (atomic%).

### (Example 5)

### -Preparation of Phase-Change Optical Recording Medium-

The phase-change optical recording medium of Example 5 was prepared similarly to Example 1, except for forming a recording layer by sputtering using a sputtering target of Ga₉Sn₂₉Cu₁₉Sb₄₃ composition (atomic%).

### (Example 6)

### -Preparation of Phase-Change Optical Recording Medium-

The phase-change optical recording medium of Example 6 was prepared similarly to Example 1, except for forming a recording layer by sputtering using a sputtering target of Ga₅Sn₁₀Cu₆Sb₇₉ composition (atomic%).

### (Example 7)

### Preparation of Phase-Change Optical Recording Medium-

The phase-change optical recording medium of Example 7 was prepared similarly to Example 1, except for forming a recording layer by sputtering using a sputtering target of Ga₁₉Sn₂₈Cu₈Sb₄₅ composition (atomic%).

### (Example 8)

### -Preparation of Phase-Change Optical Recording Medium-

The phase-change optical recording medium of Example 8 was prepared similarly to Example 1, except for forming a recording layer by sputtering using a sputtering target of Ga₈Sn₈Cu₁₅Sb₆₉ composition (atomic%).

### (Example 9)

### -Preparation of Phase-Change Optical Recording Medium-

The phase-change optical recording medium of Example 9 was prepared similarly to Example 1, except for forming a recording layer by sputtering using a sputtering target of Ga₁₈Sn₁₅Cu₄Sb₆₃ composition (atomic%).

### (Example 10)

### -Preparation of Phase-Change Optical Recording Medium-

The phase-change optical recording medium of Example 10 was prepared similarly to Example 1, except for forming a recording layer by sputtering using a sputtering target of Ga₆Sn₁₈Cu₁Sb₇₅ composition (atomic%).

### (Comparative Example 1)

### -Preparation of Phase-Change Optical Recording Medium-

The phase-change optical recording medium of Comparative Example 1 was prepared similarly to Example 1, except for forming a recording layer by sputtering using a sputtering target of Ga₃Sn₂₀Cu₆Sb₇₁ composition (atomic%).

### (Comparative Example 2)

### -Preparation of Phase-Change Optical Recording Medium-

The phase-change optical recording medium of Comparative Example 2 was prepared similarly to Example 1, except for forming a recording layer by sputtering using a sputtering target of Ga₂₂Sn₁₀Cu₅Sb₆₃ composition (atomic%).

### (Comparative Example 3)

### -Preparation of Phase-Change Optical Recording Medium-

The phase-change optical recording medium of Comparative Example 3 was prepared similarly to Example 1, except for forming a recording layer by sputtering using a sputtering target of Ga₁₀Sn₃₅Cu₇Sb₄₈ composition (atomic%).

### (Comparative Example 4)

### -Preparation of Phase-Change Optical Recording Medium-

The phase-change optical recording medium of Comparative Example 4 was prepared similarly to Example 1, except for forming a recording layer by sputtering using a sputtering target of Ga₁₀Sn₁₁Cu₂₂Sb₅₇ composition (atomic%).

### (Comparative Example 5)

### -Preparation of Phase-Change Optical Recording Medium-

The phase-change optical recording medium of Comparative Example 5 was prepared similarly to Example 1, except for forming a recording layer by sputtering using a sputtering target of Ga₅Sn₁₀Cu₅Sb₈₀ composition (atomic%).

### (Comparative Example 6)

### -Preparation of Phase-Change Optical Recording Medium-

The phase-change optical recording medium of Comparative Example 6 was prepared similarly to Example 1, except for forming a recording layer by sputtering using a sputtering target of Ga₂₀Sn₂₂Cu₂₀Sb₃₈ composition (atomic%).

### (Comparative Example 7)

### -Preparation of Phase-Change Optical Recording Medium-

The phase-change optical recording medium of Comparative Example 7 was prepared similarly to Example 1, except for forming a recording layer by sputtering using a sputtering target of Ga₁₀Sn₃Cu₄Sb₈₃ composition (atomic%).

### (Comparative Example 8)

### -Preparation of Phase-Change Optical Recording Medium-

The phase-change optical recording medium of Comparative Example 8 was prepared similarly to Example 1, except for forming a recording layer by sputtering using a sputtering target of Ga₈Sn₁₄Sb₇₈ composition (atomic%).

**Table 1**

| | Ga (atomic%) | Sn (atomic%) | Cu (atomic%) | Sb (atomic%) |
|---|---|---|---|---|
| Example 1 | 5 | 15 | 5 | 75 |
| Example 2 | 6.5 | 25 | 8.5 | 60 |
| Example 3 | 14 | 20 | 12 | 54 |
| Example 4 | 5 | 20 | 10 | 65 |
| Example 5 | 9 | 29 | 19 | 43 |
| Example 6 | 5 | 10 | 6 | 79 |
| Example 7 | 19 | 28 | 8 | 45 |
| Example 8 | 8 | 8 | 15 | 69 |
| Example 9 | 18 | 15 | 4 | 63 |
| Example 10 | 6 | 18 | 1 | 75 |

**Table 2**

| | Ga (atomic%) | Sn (atomic%) | Cu (atomic%) | Sb (atomic%) |
|---|---|---|---|---|
| Comp. Ex. 1 | 3 | 20 | 6 | 71 |
| Comp. Ex. 2 | 22 | 10 | 5 | 63 |
| Comp. Ex. 3 | 10 | 35 | 7 | 48 |
| Comp. Ex. 4 | 10 | 11 | 22 | 57 |
| Comp. Ex. 5 | 5 | 10 | 5 | 80 |
| Comp. Ex. 6 | 20 | 22 | 20 | 38 |
| Comp. Ex. 7 | 10 | 3 | 4 | 83 |
| Comp. Ex. 8 | 8 | 14 | 0 | 78 |

### <Initial Crystallization>

Initial crystallization of each obtained phase-change optical recording medium was performed by irradiating a laser beam of 20mW/µm² power density while rotating the phase-change optical recording medium at a constant linear velocity of 12m/s and moving at 36µm/r in radius direction using an initializer (POP120-7AH) by Hitachi Computer Peripherals Co., Ltd.

### <Evaluation>

The recording and reproducing were performed for each optical recording medium using a pickup of 660nm wavelength and NA0.65. Random patterns were recorded by EFM+ modulation method, a modulation method for DVD, under the condition of 28m/s recording linear velocity, 0.267µm/bit recording linear density, which is the same capacity as DVD-ROM, 30mW write power Pw and 7mW erase power Pe. Each recording strategy was optimized for recording. All reproducing was performed at 3.5m/s linear velocity and 0.7mW power.

Evaluations of distribution homogeneity within periphery after initial crystallization, modulation degree at a recording linear velocity of 28m/s, jitter of initial recording and after 100 times of overwriting and storage stability were conducted for each optical recording medium. Meanwhile, jitter is a value of data to clock jitter σ , normalized with detection window width Tw. The results are shown in Tables 3 and 4.

The evaluation standard for each evaluation item is as follow.

### <Distribution Homogeneity within Periphery after Initial Crystallization>

After performing initial crystallization under the above initialization condition, reflectance distribution within periphery was determined using an optical disc evaluation apparatus (DDU-1000) by Pulstec Industrial Co., Ltd. having a pickup of 660nm wavelength and NA0.65 and reflectance distribution within periphery = [(maximum reflectance - minimum reflectance) / maximum reflectance] x 100 was calculated. The obtained reflectance distribution within periphery was evaluated and it was indicated as ○ when the reflectance distribution within periphery was less than 10%, it was indicated as Δ when the reflectance distribution within periphery was 10% to 13% and it was indicated as × when the reflectance distribution within periphery was more than 13%. The reflectance distribution within periphery is preferably less than 10% and when it is 10% to 13%, by optimizing the initialization condition, it is possible to make the reflectance distribution within periphery to be less than 10%.

### <Modulation Degree at Recording Linear Velocity of 28m/s>

The modulation degree at a recording linear velocity of 28m/s was evaluated and it was indicated as ○ when the modulation degree was 60% or more, which is a standard value for DVD; it was indicated as ⊚ when the modulation degree was 65% or more, at which more stable system can be obtained; it was indicated as △ when the modulation degree was 55% or more and less than 60% and it was indicated as × when the modulation degree was less than 55%. The standard value of modulation degree for DVD 4 double-speed recording is 60% or more, however, if the reflectance is high, it is practically usable when the modulation degree is 55% or more.

### <Jitter of Initial Recording and After 100 Times of Overwrite Recording at Recording Linear Velocity of 28m/s>

The jitter of initial recording and after 100 times of overwrite recording at a recording linear velocity of 28m/s was evaluated and it was indicated as ○ when the jitter was less than 9%, it was indicated as △ when the jitter was 9% or more and 10% or less and it was indicated as × when the jitter was more than 10%. The standard value for jitter is less than 9%, however, when the jitter is 10% or less, it can be satisfactorily put into practical use by optimizing the layer composition.

### <Reflectance Fluctuation of Crystalline Phase after Long-Term Storage>

An acceleration test was conducted under environment of 80°C-85%RH for evaluation of reflectance fluctuation of crystalline phase after long-term storage. The reflectance of crystalline phase was measured after retaining each optical recording medium in a constant-temperature bath of 80°C-85%RH for 300 hours and when the reflectance degradation was 3% or less, it was indicated as ○. When the result was 3% or more, an optical recording medium was prepared again and the reflectance of crystalline phase was measured after retaining the optical recording medium in a constant-temperature bath of 70°C-85%RH this time for 300 hours and it was indicated as Δ when the reflectance degradation was 3% or less and it was indicated as x when the result was 3% or more. The reflectance change at 80°C is preferably small; however, considering that the most harsh usage environment of optical recording media is approximately 55°C, it is satisfactory for practical use if it can be assured at 70°C.

**Table 3**

| | Distribution Homogenity within Periphery after Initialization | Recording Modulation Degree at 8 double-speed | Jitter of Initial Recording at 8 double-speed | Jitter after 100 Times of Recording at 8 double-speed | Reflectance Fluctuation of Crystalline Phase after Long-Term Storage |
|---|---|---|---|---|---|
| Example 1 | ○ | ⊚ | ○ | ○ | ○ |
| Example 2 | ○ | ⊚ | ○ | ○ | ○ |
| Example 3 | ○ | ⊚ | ○ | ○ | ○ |
| Example 4 | ○ | ⊚ | ○ | ○ | ○ |
| Example 5 | ○ | ○ | ○ | ○ | ○ |
| Example 6 | ○ | ○ | ○ | ○ | ○ |
| Example 7 | ○ | ○ | ○ | ○ | ○ |
| Example 8 | △ | ○ | △ | △ | ○ |
| Example 9 | ○ | ○ | ○ | ○ | △ |
| Example 10 | ○ | ○ | ○ | ○ | △ |

**Table 4**

| | Distribution Homogenity within Periphery after Initialization | Recording Modulation Degree at 8 double-speed | Jitter of Initial Recording at 8 double-speed | Jitter after 100 Times of Recording at 8 double-speed | Reflectance Flucturation of Crystalline Phase after Long-Term Storage |
|---|---|---|---|---|---|
| Comp. Ex. 1 | ○ | △ | △ | × | ○ |
| Comp. Ex: 2 | △ | ○ | △ | × | ○ |
| Comp. Ex. 3 | × | × | × | × | × |
| Comp. Ex. 4 | × | × | × | × | ○ |
| Comp. Ex. 5 | △ | ○ | △ | × | △ |
| Comp. Ex. 6 | × | × | × | × | × |
| Comp. Ex. 7 | × | △ | △ | × | △ |
| Comp. Ex. 8 | ○ | ○ | ○ | ○ | × |

Each optical recording medium of Examples 1 to 10 had excellent distribution homogeneity within periphery after initialization and jitter of initial recording and after 100 times of recording at DVD 8 double-speed were also appropriate. And the modulation degrees at which stable system can be obtained were 65% or more and particularly preferable in Examples 1 to 4 and the reflectance degradation were also small as regard to storage stability. When a recording was performed at a recording linear velocity of 28m/s for each optical recording medium of Examples 1 to 10 after retaining each optical recording medium in a constant-temperature bath of 80°C85%RH for 300 hours, resulted jitter was 9% or less.

At the same time, recording modulation degree at 8 double-speed and recording jitter of Comparative Example 1 were inappropriate. Particularly overwriting performance at 8 double-speed and homogeneity within periphery after initial crystallization of Comparative Example 2 were inappropriate. Amorphousization was difficult for Comparative Example 3 because crystallization speed was too much and recording at 8 double-speed was impossible. Recording at 8 double-speed was also impossible for Comparative Example 4 because crystallization speed was too slow. The distribution homogeneity within periphery after initial crystallization and recording jitter of Comparative Example 5 were inappropriate. Amorphousization was difficult for Comparative Example 6 because crystallization speed was too much and recording at 8 double-speed was impossible. The distribution homogeneity within periphery after initial crystallization and recording jitter of Comparative Example 7 were inappropriate. The reflectance fluctuation of crystalline phase after long-term storage of Comparative Example 8 was large because it does not contain Cu.

### (Example 11)

### -Relation between Layer Thickness of Reflective Layer and Modulation Degree-

7 optical recording media were prepared similarly to Example 2, except for altering each layer thickness of the reflective layer to 40nm, 60nm, 120nm, 140nm, 200nm, 250nm and 300nm respectively.

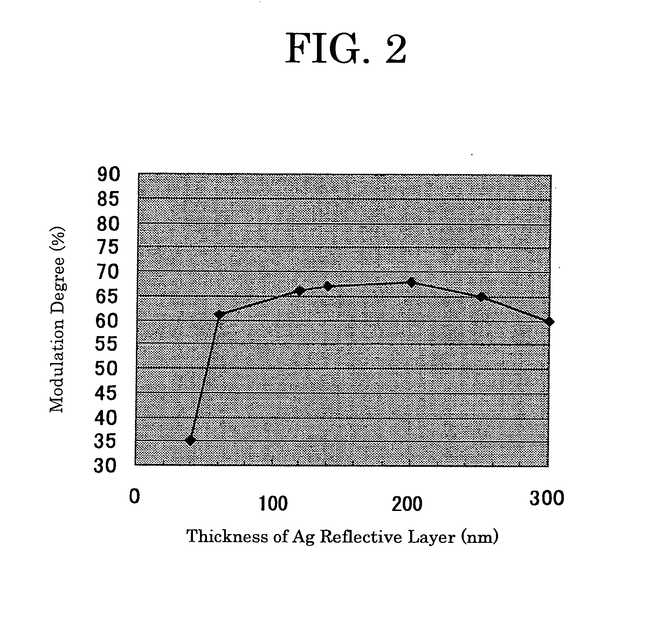

The modulation degree at a recording linear velocity of 28m/s for each obtained optical recording medium was investigated. The results are shown in FIG. 2.

From the results shown in FIG. 2, it turns out that modulation degree was 60% or more when the layer thickness of the reflective layer was 60nm to 300nm and particularly when the layer thickness of the reflective layer was 120nm to 250nm, the modulation degree becomes 65% or more, which is a satisfying modulation degree to obtain stable systems.

### (Example 12)

An optical recording medium was prepared similarly to Example 4, except for changing the material of the reflective layer from Ag to AlTi (Ti=1% by mass).

The modulation degree at a recording linear velocity of 28m/s of the obtained optical recording medium was investigated and it was found to be as small as 52%.

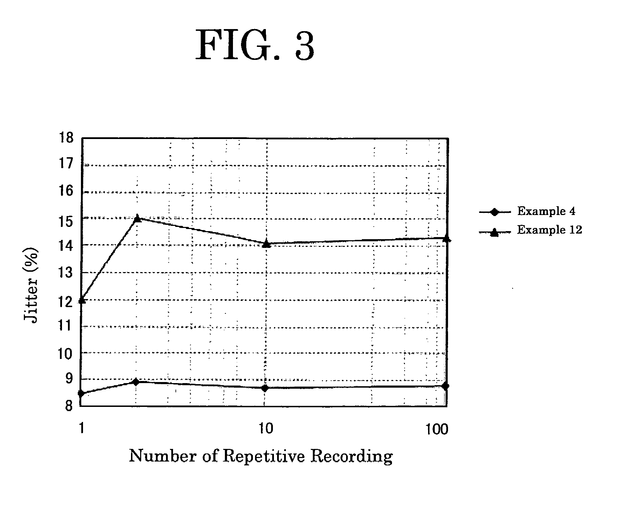

The resulted repetition performance at a recording linear velocity of 28m/s for each optical recording medium of Examples 4 and 12 are shown in FIG. 3.

### (Example 13)

### -Preparation of Phase-Change Optical Recording Medium-

A polycarbonate resin substrate of 12cm diameter and 0.6mm thickness, having a guide groove of 0.74µm track pitch and 400Å groove depth, was provided. On the substrate, a first intermediate layer, a recording layer, a second intermediate layer, a third intermediate layer and a reflective layer were formed in this order by sputtering using a sheet sputtering apparatus (Big Sprinter by Unaxis Incorporated) under Ar gas atmosphere.

First, using a sputtering target of (ZnS)₈₀ (SiO₂)₂₀ composition (mole percent), a first intermediate layer of 70nm thickness was formed on the substrate by sputtering.

Next, using a sputtering target of Ga₁₈Sn₂₀In₃Cu₁₆Sb₄₃ composition (atomic percent), a recording layer of 16nm thickness was formed on the first intermediate layer by sputtering. The target for the recording layer was made in form of a disk by weighing the feed amount in advance, pulverizing by means of a pulverizer after being heat melted in a glass ampoule and taken out, and then heat sintering the obtained powder. When the composition ratio of the recording layer after formation was measured by inductively-coupled plasma (ICP) emission spectrometry, it was the same composition ratio as the feed amount of the target. A sequential ICP emission spectrophotometer (SPS4000 by Seiko Instruments Inc.) was used for the ICP emission spectrometry. Meanwhile, the alloy compositions of the recording layer and the sputtering target are identical to each other in Examples and Comparative Examples, which will be described later.

Next, using the sputtering target of (ZnS)₈₀ (SiO₂)₂₀ composition (mole percent), a second intermediate layer of 10nm thickness was formed on the recording layer by sputtering.

Next, using a sputtering target of SiC, a third intermediate layer of 4nm thickness was formed on the second intermediate layer by sputtering.

Next, using a sputtering target of Ag, a reflective layer of 140nm thickness was formed on the third intermediate layer by sputtering.

Next, an organic protective layer was formed by applying acrylic curable resin (SD318 by Dainippon Ink and Chemicals, Inc.) of 5µm to 10µm thickness on the reflective layer by spincoating and ultraviolet-curing.

Finally, a polycarbonate resin substrate of 12cm diameter and 0.6mm thickness was bonded onto the organic protective layer using an ultraviolet curable resin (DVD003 by Nippon Chemical Industrial Co., Ltd.). With the above procedures, the phase-change optical recording medium of Example 13 was prepared.

### (Example 14)

### -Preparation of Phase-Change Optical Recording Medium-

The phase-change optical recording medium of Example 14 was prepared similarly to Example 13, except for forming the recording layer by sputtering using a sputtering target of Ga₉Sn₁₅In₆Cu₁₂Sb₅₈ composition (atomic percent).

### (Example 15)

### -Preparation of Phase-Change Optical Recording Medium-

The phase-change optical recording medium of Example 15 was prepared similarly to Example 13, except for forming the recording layer by sputtering using a sputtering target of Ga₁₅Sn₁₄In₅Cu₆Sb₆₀ composition (atomic percent).

### (Example 16)

### -Preparation of Phase-Change Optical Recording Medium-

The phase-change optical recording medium of Example 16 was prepared similarly to Example 13, except for forming the recording layer by sputtering using a sputtering target of Ga₈Sn₅In₉Cu₅Sb₇₃ composition (atomic percent).

### (Example 17)

### -Preparation of Phase-Change Optical Recording Medium-

The phase-change optical recording medium of Example 17 was prepared similarly to Example 13, except for forming the recording layer by sputtering using a sputtering target of Ga₅Sn₇In₆Cu₃Sb₇₉ composition (atomic percent).

### (Example 18)

### -Preparation of Phase-Change Optical Recording Medium-

The phase-change optical recording medium of Example 18 was prepared similarly to Example 13, except for forming the recording layer by sputtering using a sputtering target of Ga₅Sn₃In₁₉Cu₄Sb₆₉ composition (atomic percent).

### (Example 19)

### -Preparation of Phase-Change Optical Recording Medium-

The phase-change optical recording medium of Example 19 was prepared similarly to Example 13, except for forming the recording layer by sputtering using a sputtering target of Ga₈Sn₁₄In₁Cu₅Sb₇₂ composition (atomic percent).

### (Example 20)

### -Preparation of Phase-Change Optical Recording Medium-

The phase-change optical recording medium of Example 20 was prepared similarly to Example 13, except for forming the recording layer by sputtering using a sputtering target of Ga₁₀Sn₁₈In₆Cu₁Sb₆₅ composition (atomic percent).

### (Example 21)

### -Preparation of Phase-Change Optical Recording Medium-

The phase-change optical recording medium of Example 21 was prepared similarly to Example 13, except for forming the recording layer by sputtering using a sputtering target of Ga₅Sn₂₁In₁₀Cu₂Sb₆₂ composition (atomic percent).

### (Comparative Example 9)

### -Preparation of Phase-Change Optical Recording Medium-

The phase-change optical recording medium of Comparative Example 9 was prepared similarly to Example 13, except for forming the recording layer by sputtering using a sputtering target of Ga₂₁Sn₁₉In₅Cu₇Sb₄₈ composition (atomic percent).

### (Comparative Example 10)

### -Preparation of Phase-Change Optical Recording Medium-

The phase-change optical recording medium of Comparative Example 10 was prepared similarly to Example 13, except for forming the recording layer by sputtering using a sputtering target of Ga₅Sn₈In₈Cu₂₁Sb₅₈ composition (atomic percent).

### (Comparative Example 11)

### -Preparation of Phase-Change Optical Recording Medium-

The phase-change optical recording medium of Comparative Example 11 was prepared similarly to Example 13, except for forming the recording layer by sputtering using a sputtering target of Ga₈Sn₈In₂₁Cu₃Sb₆₀ composition (atomic percent).

### (Comparative Example 12)

### -Preparation of Phase-Change Optical Recording Medium-

The phase-change optical recording medium of Comparative Example 12 was prepared similarly to Example 13, except for forming the recording layer by sputtering using a sputtering target of Ga₁₅Sn₁In₁₂Cu₃Sb₆₉ composition (atomic percent).

### (Comparative Example 13)

### -Preparation of Phase-Change Optical Recording Medium-

The phase-change optical recording medium of Comparative Example 13 was prepared similarly to Example 13, except for forming the recording layer by sputtering using a sputtering target of Ga₄Sn₇In₁₂Cu₆Sb₇₁ composition (atomic percent).

### (Comparative Example 14)

### -Preparation of Phase-Change Optical Recording Medium-

The phase-change optical recording medium of Comparative Example 14 was prepared similarly to Example 13, except for forming the recording layer by sputtering using a sputtering target of Ga₅Sn₂In₅Cu₇Sb₈₁ composition (atomic percent).

### (Comparative Example 15)

### -Preparation of Phase-Change Optical Recording Medium-

The phase-change optical recording medium of Comparative Example 15 was prepared similarly to Example 13, except for forming the recording layer by sputtering using a sputtering target of Ga₁₄Sn₁₈In₂₀Cu₉Sb₃₉ composition (atomic percent).

**Table 5**

| | Ga (atomic%) | Sn (atomic%) | In (atomic%) | Cu (atomic%) | Sb (atomic%) |
|---|---|---|---|---|---|
| Example 13 | 18 | 20 | 3 | 16 | 43 |
| Example 14 | 9 | 15 | 6 | 12 | 58 |
| Example 15 | 15 | 14 | 5 | 6 | 60 |
| Example 16 | 8 | 5 | 9 | 5 | 73 |
| Example 17 | 5 | 7 | 6 | 3 | 79 |
| Example 18 | 5 | 3 | 19 | 4 | 69 |
| Example 19 | 8 | 14 | 1 | 5 | 72 |
| Example 20 | 10 | 18 | 6 | 1 | 65 |
| Example 21 | 5 | 21 | 10 | 2 | 62 |

**Table 6**

| | Ga (atomic%) | Sn (atomic%) | In (atomic%) | Cu (atomic%) | Sb (atomic%) |
|---|---|---|---|---|---|
| Comp. Ex. 9 | 21 | 19 | 5 | 7 | 48 |
| Comp. Ex. 10 | 5 | 8 | 8 | 21 | 58 |
| Comp. Ex. 11 | 8 | 8 | 21 | 3 | 60 |
| Comp. Ex. 12 | 15 | 1 | 12 | 3 | 69 |
| Comp. Ex. 13 | 4 | 7 | 12 | 6 | 71 |
| Comp. Ex. 14 | 5 | 2 | 5 | 7 | 81 |
| Comp. Ex. 15 | 14 | 18 | 20 | 9 | 39 |

### <Initial Crystallization>

Initial crystallization of each obtained phase-change optical recording medium was performed by irradiating a laser beam of 20mW/µm² power density while rotating the phase-change optical recording medium at a constant linear velocity of 12m/s and moving at 36µm/r in radius direction using an initializer (POP120-7AH) by Hitachi Computer Peripherals Co., Ltd.

### <Evaluation>

The recording and reproducing were performed for each optical recording medium using a pickup of 660nm wavelength and NA0.65. Random patterns were recorded by EFM+ modulation method, a modulation method for DVD, under a recording condition of 35m/s recording linear velocity, 0.267µm/bit recording linear density, which is the same capacity as DVD-ROM, 32mW write power Pw and 6.5mW erase power Pe. Each recording strategy was optimized. All reproducing was performed at 3.5m/s linear velocity and 0.7mW power.

Evaluations of distribution homogeneity within periphery after initial crystallization, modulation degree at a recording linear velocity of 35m/s, jitter of initial recording and after 100 times of overwriting and storage stability were conducted for each optical recording medium. Meanwhile, jitter is a value of data to clock jitter σ, normalized with detection window width Tw. The results are shown in Tables 7 and 8.

The evaluation standard of each evaluation item is as follow.

### <Distribution Homogeneity within Periphery after Initial Crystallization>

After performing initial crystallization under the above initialization condition, reflectance distribution within periphery was determined using an optical disc evaluation apparatus (DDU-1000) by Pulstec Industrial Co., Ltd. having a pickup of 660nm wavelength and NA0.65 and reflectance distribution within periphery = [(maximum reflectance - minimum reflectance) / maximum reflectance] x 100 was calculated. The obtained reflectance distribution within periphery was evaluated and it was indicated as ○ when the reflectance distribution within periphery was less than 10%, it was indicated as △ when the reflectance distribution within periphery was 10% to 13% and it was indicated as x when the reflectance distribution within periphery was more than 13%. The reflectance distribution within periphery is preferably less than 10% and when it is 10% to 13%, by optimizing the initialization condition, it is possible to make the reflectance distribution within periphery to be less than 10%.

### <Modulation Degree at Recording Linear Velocity of 35m/s>

The modulation degree at a recording linear velocity of 35m/s was evaluated and it was indicated as ○ when the modulation degree was 60% or more, which is a standard value for DVD, it was indicated as ⊚ when the modulation degree was 65% or more, at which more stable system can be obtained, it was indicated as △ when the modulation degree was 55% or more and less than 60%, and it was indicated as × when the modulation degree was less than 55%. The standard value of modulation degree for DVD 4 double-speed recording is 60% or more, however, when the reflectance is high, it is practically usable when the modulation degree is 55% or more.

### <Jitter of Initial Recording and After 100 Times of Overwrite Recording at Recording Linear Velocity of 35m/s>

The jitter of initial recording and after 100 times of overwrite recording at a recording linear velocity of 35m/s were evaluated and it was indicated as ○ when the jitter was less than 9%, it was indicated as △ when the jitter was 9% or more and 10% or less and it was indicated as x when the jitter was more than 10%. The standard value of jitter is less than 9%; however, when the jitter is 10% or less, it can be satisfactorily put into practical use by optimizing the layer composition.

### <Reflectance Fluctuation of Crystalline Phase after Long-Term Storage>

An acceleration test was conducted under environment of 80°C-85%RH for evaluation of reflectance fluctuation of crystalline phase after long-term storage. The reflectance of crystalline phase was measured after retaining each optical recording medium in a constant-temperature bath of 80°C-85%RH for 300 hours and when the reflectance degradation was 3% or less, it was indicated as ○. When the result was above 3%, an optical recording medium was prepared again and the reflectance of crystalline phase was measured after retaining the optical recording medium in a constant- temperature bath of 70°C-85%RH at this time for 300 hours and it was indicated as △ when the reflectance degradation was 3% or less and it was indicated as × when the result was above 3%. The reflectance change at 80°C is preferably small; however, considering that the most harsh usage environment of optical recording media is approximately 55°C, it is satisfactory for practical use if it can be assured at 70°C.

**Table 7**

| | Distribution Homogeneity within Periphery after Initialization | Recording Modulation Degree at 10 double-speed | Jitter of Initial Recording at 10 double-speed | Jitter after 100 times of Recording at 10 double-speed | Storage Stability |
|---|---|---|---|---|---|
| Example 13 | ○ | ○ | ○ | ○ | ○ |
| Example 14 | ○ | ⊚ | ○ | ○ | ○ |
| Example 15 | ○ | ⊚ | ○ | ○ | ○ |
| Example 16 | ○ | ⊚ | ○ | ○ | ○ |
| Example 17 | ○ | ○ | ○ | ○ | ○ |
| Example 18 | ○ | ○ | ○ | ○ | ○ |
| Example 19 | ○ | △ | △ | △ | ○ |
| Example 20 | ○ | ○ | ○ | ○ | △ |
| Example 21 | ○ | △ | △ | △ | ○ |

**Table8**

| | Distribution Homogeneity within Periphery after Initialization | Recording Modulation Degree at 10 double-speed | Jitter of Initial Recording at 10 double-speed | Jitter after 100 times of Recording at 10 double-speed | Storage Stability |
|---|---|---|---|---|---|
| Comp. Ex. 9 | ○ | △ | × | × | ○ |
| Comp. Ex. 10 | ○ | × | × | × | ○ |
| Comp. Ex. 11 | ○ | △ | × | × | ○ |
| Comp. Ex. 12 | × | △ | △ | × | ○ |
| Comp. Ex. 13 | ○ | △ | △ | × | ○ |
| Comp. Ex. 14 | × | △ | △ | × | ○ |
| Comp. Ex. 15 | ○ | × | × | × | ○ |

Each optical recording medium of Examples 13 to 21 had excellent distribution homogeneity within periphery after initialization and the jitter of initial recording and after 100 times of recording at DVD 10 double-speed were also appropriate. And the modulation degree at which stable system can be obtained was 65% or more and they were particularly preferable with the composition range of Examples 14 to 16. Moreover, the reflectance degradation were also small as regard to storage stability. When a recording was performed at a recording linear velocity of 35m/s for each optical recording medium of Examples 13 to 18 after retaining the optical recording media in a constant-temperature bath of 80°C-85%RH for 300 hours, resulted jitter was 9% or less.

At the same time, it was impossible to perform overwrite recording at DVD 10 double-speed in the optical recording media of Comparative Examples 9 and 10 because crystallization speed was slowed too much. Amorphousization in the optical recording medium of Comparative Example 11 was difficult as for the Comparative Examples 9 and the modulation degree was small. The distribution homogeneity within periphery after initial crystallization and recording jitter of the optical recording medium of Comparative Example 12 were inappropriate. The recording jitter of the optical recording medium of Comparative Example 13 was inappropriate and amorphous marks disappeared after the acceleration test under environment of 80°C-85%RH. The distribution homogeneity within periphery after initial crystallization and recording jitter of the optical recording medium of Comparative Example 14 were inappropriate. Amorphousization was difficult in the optical recording medium of Comparative Example 15.

### (Example 22)

5 optical recording media were prepared similarly to Example 14, except for altering each layer thickness of the reflective layer to 40nm, 60nm, 200nm, 250nm and 300nm respectively.

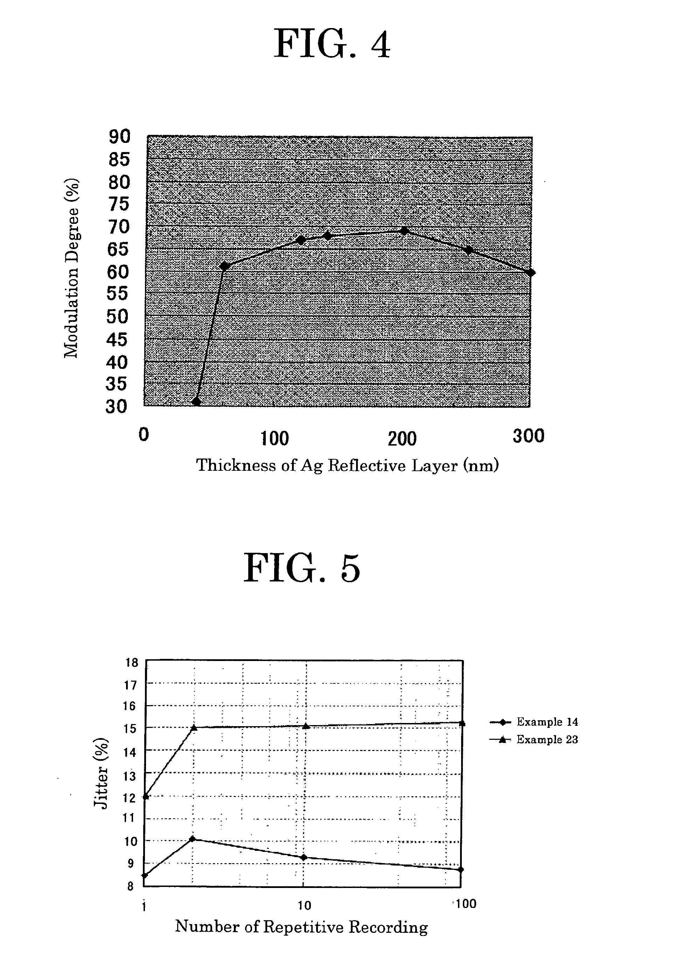

The modulation degree at a recording linear velocity of 35m/s for each obtained optical recording medium was investigated. The results are shown in FIG. 4.

From the results shown in FIG. 4, it turns out that the modulation degree is 60% or more when the layer thickness of the reflective layer is 60nm to 300nm and particularly when the layer thickness of the reflective layer is 120nm to 250nm, the modulation degree becomes 65% or more, which is a satisfying modulation degree to obtain stable systems.

### (Example 23)

An optical recording medium was prepared similarly to Example 14, except for changing the material of the reflective layer from Ag to AlTi (Ti=1% by mass).

The modulation degree at a recording linear velocity of 35m/s of the obtained optical recording medium was investigated and it was found to be as small as 45%.

The resulted repetitive recording performance of Example 23 at a recording linear velocity of 35m/s, which was evaluated as similar to Examples 13 to 21, is shown in FIG. 5 with the result of Example 14.

### Industrial Applicability

The phase-change optical recording medium of the present invention is capable of highly reliable recording with as much capacity as DVD-ROM even at a recording linear velocity of 8 double-speed (recording linear velocity = about 28m/sec.) or more and it is widely applicable for various optical recording media, particularly for DVD optical recording media such as DVD-RAM, DVD-RW, DVD+RW, etc.

## Claims

1. A phase-change optical recording medium comprising:
a substrate, and
at least a first intermediate layer, a recording layer, a second intermediate layer, and a reflective layer disposed on the substrate in one of this order and reverse order,
wherein the recording layer comprises a composition expressed by the following formula, Ga_{α}Sn_{β}Cu_{γ}Sb_{δ}M_{ε} where "M" represents at least one element selected from elements and mixtures thereof other than Ga, Sn, Cu and Sb and α, β, γ, δ and ε respectively represent atomic composition ratio of each element and satisfy the following relations: 5 ≤ α ≤ 20, 2 ≤ β ≤ 30, 1 ≤ γ ≤ 20, 40 ≤ δ < 80, 0 ≤ ε ≤ 20 and α + β + γ + δ + ε = 100.

2. The phase-change optical recording medium according to claim 1, wherein the recording layer comprises the composition expressed by the following formula, Ga_{α}Sn_{β}Cu_{γ}Sb_{δ} where α, β, γ and δ respectively represent atomic composition ratio of each element and satisfy the following relations: 5 ≤ α ≤ 20, 10 ≤ β ≤ 30, 1 ≤ γ ≤ 20, 40 ≤ δ < 80 and α + β + γ + δ = 100.

3. The phase-change optical recording medium according to claim 2, wherein the recording layer comprises the composition expressed by the following formula, Ga_{α}Sn_{β}Cu_{γ}Sb_{δ} where α, β, γ and δ respectively represent atomic composition ratio of each element and satisfy the following relations: 5 ≤ α ≤ 15, 15 ≤ β ≤ 25, 1 ≤ γ ≤ 15, 50 ≤ δ ≤ 75 and α + β + γ + δ = 100.

4. The phase-change optical recording medium according to claim 1, wherein "M" is at least one selected from In, Te, Bi, Al, Zn, Ni, Mn, Cr, Mo and Hf.

5. The phase-change optical recording medium according to any one of claims 1 to 4, wherein the recording layer comprises a composition expressed by the following formula, Ga_{α}Sn_{β}Cu_{γ}Sb_{δ}In_{ε} where α, β, γ, δ and ε respectively represent atomic composition ratio of each element and satisfy the following relations: 5 ≤ α ≤ 20, 2 ≤ β ≤ 20, 1 ≤ γ ≤ 20, 40 ≤ δ < 80, 2 ≤ ε ≤ 20 and α + β + γ + δ + ε = 100.

6. The phase-change optical recording medium according to claim 5, wherein the recording layer comprises the composition expressed by the following formula, Ga_{α}Sn_{β}Cu_{γ}Sb_{δ}In_{ε} where α, β, γ, δ and ε respectively represent atomic composition ratio of each element and satisfy the following relations: 8 ≤ α ≤ 16, 5 ≤ β ≤ 15, 1 ≤ γ ≤ 15, 55 ≤ δ ≤ 75, 5 ≤ ε ≤ 15 and α + β + γ + δ + ε = 100.

7. The phase-change optical recording medium according to any one of claims 1 to 6, wherein at least one of recording, reproducing, erasing and rewriting of information is performed in the recording layer through reversible phase changes between amorphous phase and crystalline phase.

8. The phase-change optical recording medium according to any one of claims 1 to 7, wherein the first intermediate layer and the second intermediate layer comprise a mixture of ZnS and SiO₂.

9. The phase-change optical recording medium according to any one of claims 1 to 8, wherein an interface layer is disposed between the recording layer and the first intermediate layer.

10. The phase-change optical recording medium according to any one of claims 1 to 9, wherein the reflective layer comprises one of Ag and Ag alloy.

11. The phase-change optical recording medium according to any one of claims 1 to 10, wherein the thickness of the reflective layer is 60nm to 300nm.

12. The phase-change optical recording medium according to claim 11, wherein the thickness of the reflective layer is 120nm to 250nm.

13. The phase-change optical recording medium according to any one of claims 1 to 12, wherein a third intermediate layer is disposed between the second intermediate layer and the reflective layer.

14. A sputtering target comprising:
a composition expressed by the following formula, Ga_{α}Sn_{β}Cu_{γ}Sb_{δ}M_{ε}
where "M" represents at least one element selected from elements and mixtures thereof other than Ga, Sn, Cu and Sb and α, β, γ, δ and ε respectively represent atomic composition ratio of each element and satisfy the following relations: 5 ≤ α ≤ 20, 2 ≤ β ≤ 30, 1 ≤ γ ≤ 20, 40 ≤ δ < 80, 0 ≤ ε ≤ 20 and α + γ + δ + ε = 100, and
wherein the sputtering target is used for manufacturing the recording layer.

15. The sputtering target according to claim 14, wherein the sputtering target comprises the composition expressed by the following formula, Ga_{α}Sn_{β}Cu_{γ}Sb_{δ} where α, β, γ and δ respectively represent atomic composition ratio of each element and satisfy the following relations: 5 ≤ α ≤ 20, 10 ≤ β ≤ 30, 1 ≤ γ ≤ 20, 40 ≤ δ < 80 and α + β + γ + δ = 100.

16. The sputtering target according to claim 15, wherein the sputtering target comprises the composition expressed by the following formula, Ga_{α}Sn_{β}Cu_{γ}Sb_{δ} where α, β, γ and δ respectively represent atomic composition ratio of each element and satisfy the following relations: 5 ≤ α ≤ 15, 15 ≤ β ≤ 25, 1 ≤ γ ≤ 15, 50 ≤ δ ≤ 75 and α + β + γ + δ = 100.

17. The sputtering target according to claim 14, wherein "M" is at least one selected from In, Te, Bi, Al, Zn, Ni, Mn, Cr, Mo and Hf.

18. The sputtering target according to any one of claims 14 to 17, wherein the sputtering target comprises the composition expressed by the following formula, Ga_{α}Sn_{β}Cu_{γ}Sb_{δ}In_{ε} where α, β, γ, δ and ε respectively represent atomic composition ratio of each element and satisfy the following relations: 5 ≤ α ≤ 20, 2 ≤ β ≤ 20, 1 ≤ γ ≤ 20, 40 ≤ δ < 80, 2 ≤ ε ≤ 20 and α + β + γ + δ + ε = 100.

19. The sputtering target according to claim 18, wherein the sputtering target comprises the composition expressed by the following formula, Ga_{α}Sn_{β}Cu_{γ}Sb_{δ}In_{ε} where α, β, γ, δ and ε respectively represent atomic composition ratio of each element and satisfy the following relations: 8 ≤ α ≤ 16, 5 ≤ β ≤ 15, 1 ≤ γ ≤ 15, 55 ≤ δ ≤ 75, 5 ≤ ε ≤ 15 and α + β + γ + δ + ε = 100.

20. A manufacturing method of a phase-change optical recording medium comprising:
recording-layer forming to form a recording layer by sputtering using the sputtering target according to any one of claims 14 to 19,
wherein the phase-change optical recording medium comprises a first intermediate layer, a recording layer, a second intermediate layer and a reflective layer disposed on the substrate in one of this order and reverse order.

21. A method for using a phase-change optical recording medium comprising:
a laser beam irradiation from the first intermediate layer side of the phase-change optical recording medium to perform at least one of recording, reproducing, erasing and rewriting of information,
wherein the phase-change optical recording medium is the phase-change optical recording medium according to any one of claims 1 to 13.

22. An optical recording apparatus comprising:
a laser beam source configured to irradiate a laser beam to a phase-change optical recording medium to perform at least one of recording, reproducing, erasing and rewriting of information,
wherein the phase-change optical recording medium is the phase-change optical recording medium according to any one of claims 1 to 13.
